# EUROPÄISCHE PATENTSCHRIFT

(11) **EP 4 575 384 B1**
(45) Veröffentlichungstag und Bekanntmachung des Hinweises auf die Patenterteilung: **26.08.2026**
(21) Anmeldenummer: 24219301.9
(22) Anmeldetag: 12.12.2024
(51) Int. Cl.: F41H 13/00

(54) **SKALIERBARE HPEM-WIRKANORDNUNG GEGEN BEDROHUNGEN MIT MEHREREN ZIELEN**
SCALABLE HPEM COUNTER-MEASURE FOR MULTI-OBJECTIVE THREATS
AGENCEMENT DE CIBLAGE DE HPEM ÉVOLUTIF CONTRE DES MENACES CIBLES MULTIPLES

(30) Priorität: 22.12.2023 DE 102023005328
(43) Veröffentlichungstag der Anmeldung: 25.06.2025
(73) Patentinhaber: Diehl Defence GmbH & Co. KG, 88662 Überlingen (DE)
(72) Erfinder: Schwarz, Martin, 91166 Georgensgmünd (DE); Stark, Robert, 91438 Bad Windsheim (DE)
(74) Vertreter: Diehl Patentabteilung

(56) Entgegenhaltungen:
- DE-A1- 102018 008 381
- US-A1- 2022 082 358
- US-B1- 10 907 940
- US-B2- 10 760 879

## Beschreibung

Die Erfindung betrifft eine HPEM-Wirkanordnung (High Power Electro-Magnetics), die wenigstens zwei HPEM-Quellen zur Aussendung jeweiliger HPEM-Pulse enthält.

Aus der Praxis ist folgendes bekannt:
Es existieren HPEM Wirksysteme in Form von Array-Systemen und Technologie basierend auf Vakuum- und / oder Spark Gap Technologie; Narrow Band (NB), Wide Band (WB), Ultra Wide Band (UWB) HPEM Systeme die eine singuläre Frequenz mit einer sehr geringen Bandbreite oder eine Mittenfrequenz mit einer Bandbreite von bis zu 100 % oder höher abstrahlen. Bekannte Systeme werden durch US 10 907 940 B1, US 2022/082358 A1 und DE 10 2018 008381 A1 offenbart.

Die abgestrahlten Wellen oder HPEM Impulse (Pulse) von bis zu mehreren 100 MW oder GW haben dabei technologieabhängig dieselbe Wellenlänge oder Impulsform und damit jeweils eine entsprechende Mittenfrequenz und Bandbreite. Solche Systeme sind in der Regel speziell für die Abwehr von Bedrohungen bzw. Zielen einer definierten Targetklasse (z.B. UAS - unmanned aerial system oder IED - improvised explosive device) oder Gruppe von Targets (Zielen) innerhalb einer Targetklasse mit ähnlicher Empfindlichkeit / Empfindlichkeitsspektrum ausgelegt und dafür gut geeignet.

Durch phasensynchrone Ansteuerung mehrerer identischer Systeme / Antennen (Quellen) in einem Array oder die Synchronisierung mehrerer verteilter Systeme, können Wellenzüge und Impulse (Pulse) zeitlich aufeinander abgestimmt und synchronisiert werden, so dass sich die Wellenfronten im Fernfeld konstruktiv überlagern. Dadurch kann die Feldamplitude im Fernfeld und damit die Reichweite des Gesamtsystems (Wirkanordnung) erhöht und die Wirkung auf das Target (Ziel) fokussiert werden.

Durch gezielte zeitliche Verschiebung der Phasenfronten der Einzelsysteme (Quellen) gegeneinander kann die Ausrichtung bzw. der Abstrahlwinkel des HPEM Strahles bzw. der abgestrahlten Wellenfront (Puls) manipuliert bzw. eingestellt werden (sogenanntes "Beam Steering").

Als nachteilig ist dabei der recht große zeitliche Jitter z.B. bei Systemen basierend auf Spark Gap Technologie zu sehen. Ein hoher zeitlicher Jitter führt letztendlich zu einer hohen Ungenauigkeit bei der Synchronisation der Systeme (Quellen), so dass nur eine sehr begrenzte Anzahl solcher Systeme sinnvoll miteinander synchronisiert werden kann. Dadurch ist die Steigerung der Reichweite durch parallelen, synchronisierten Betrieb solcher Anlagen und Systeme (Wirkanordnung) begrenzt.

Die abstrahlenden Elemente / Antennen (Quellen) befinden sich dabei jeweils in einem Array oder können auch lokal verteilt angeordnet sein. Die Bereitstellung der Primärenergie (zur Speisung der Quellen) erfolgt dabei i.R. durch eine zentrale Energieversorgung. Bei delokalisierten Array-Systemen ist auch eine dezentrale Energieversorgung (Batterie, Netz etc.) möglich.

Die Synchronisation muss über einen Master-Timer erfolgen. Eine entsprechend zeitscharfe Synchronisation zur gezielten konstruktiven Überlagerung der Wellenfronten mehrerer verteilter Systeme (Quellen), ist aufgrund der hohen zeitlichen Jitter insbesondere bei höheren abgestrahlten Frequenzen schwer möglich.

Neuere Anlagen (Quellen) basierend auf Halbleitertechnologie emittieren singuläre Frequenzen mit einer sehr kleinen Bandbreite und deutlich geringerer Leistung. Dadurch ist der Einsatzbereich gegen unterschiedliche Targets (Ziele) und Targetklassen sehr begrenzt.

Aufgabe der Erfindung ist es, Verbesserungen in Bezug auf die Bekämpfung einer Bedrohung vorzuschlagen.

Die Aufgabe wird gelöst durch eine Wirkanordnung gemäß Patentanspruch 1. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Die Wirkanordnung dient bzw. ist eingerichtet zur Bekämpfung einer Bedrohung. Die Bedrohung enthält bzw. stellt sich dar in Form wenigstens eines, insbesondere mehrerer Ziele. Die Wirkanordnung enthält wenigstens zwei HPEM-Quellen. Jede der HPEM-Quellen ist dazu eingerichtet, jeweilige HPEM-Pulse auf die Bedrohung hin auszusenden. Wenigstens zwei der Quellen sind unabhängig voneinander zur Aussendung der HPEM Pulse ansteuerbar, insbesondere beliebige Arten von Pulsen zu beliebigen Zeitpunkten, in beliebige Richtungen, so dass z.B. zwei verschiedene Ziele individuell bestrahlt werden können.

Die Wirkanordnung enthält einen Eingang und / oder einen Speicher. Wenigstens eine Missionsvorgabe für bzw. in Bezug auf die Bekämpfung der Bedrohung und / oder eine Priorisierung von Zielen der Bedrohung ist über den Eingang in die Wirkanordnung eingebbar oder in dem Speicher speicherbar. Mit anderen Worten können die entsprechenden Größen so der Wirkanordnung bereitgestellt werden. Missionsvorgabe und / oder Priorisierung führen damit zu einem Bekämpfungsszenario in Bezug auf die Bedrohung. Mit anderen Worten wird so festgelegt, welche Ziele z.B. in welcher Reihenfolge mit welchen Pulsen zu bekämpfen sind.

Die Wirkanordnung enthält eine Steuereinrichtung. Diese ist dazu eingerichtet, wie folgt vorzugehen bzw. folgendes Verfahren auszuführen:
Der Bedrohung wird wenigstens eines von mehreren vorgebbaren Bedrohungsszenarien zugeordnet. Dadurch wird die Bedrohung klassifiziert, so dass z.B. bestimmte vorentworfene Strategien zu deren Bekämpfung ergriffen werden können.

Der Bedrohung wird wenigstens eine von mehreren vorgebbaren Zielklassen zugeordnet. Insbesondere bezieht sich eine jeweilige Zielklasse auf ein jeweiliges Ziel der Bedrohung. Auch dies dient zur Festlegung einer Bekämpfungsstrategie - insbesondere in Bezug auf die Ziele der Bedrohung.

Das Bedrohungsszenario beschreibt also die Bedrohung in ihrer Gesamtheit, insbesondere als Konglomerat von Zielen. Die Zielklassen beschreiben die jeweiligen Ziele möglichst individuell.

Der Bedrohung wird wenigstens eine von mehreren vorgebbaren HPEM-Charakteristiken zugeordnet. Dies geschieht abhängig von den zugeordneten Bedrohungsszenarien und / oder den zugeordneten Zielklassen. Die HPEM Charakteristiken beschreiben, welche Eigenschaften, zum Beispiel Widerstandsfähigkeit, die Bedrohung, insbesondere deren Ziele in Bezug auf die Bestrahlung mit verschiedenen HPEM-Pulsen aufweist.

Der Bedrohung wird wenigstens eine der Quellen zugeordnet. Auch dies geschieht abhängig von den zugeordneten Bedrohungsszenarien und / oder den zugeordneten Zielklassen und / oder den zugeordneten HPEM Charakteristiken. Mit anderen Worten werden je nach Bedrohung / Zielen und deren Eigenschaften Quellen der Wirkanordnung ausgewählt bzw. zugeordnet, welche die Bedrohung bzw. die entsprechenden Ziele möglichst erfolgreich bekämpfen können, indem sie HPEM-Pulse dorthin aussenden.

Nun werden die Quellen zur Bekämpfung der Bedrohung angesteuert, so dass diese die Pulse aussenden. Dies geschieht einerseits abhängig von den zugeordneten Bedrohungsszenarien und / oder den zugeordneten Zielklassen und / oder den zugeordneten HPEM Charakteristiken. Andererseits geschieht dies abhängig von den Missionsvorgaben und / oder den Priorisierungen. Mit anderen Worten werden die Quellen damit geeignet betrieben, um die Bedrohung optimal abzuwehren. Dies geschieht insbesondere durch Anpassung der Betriebsweise der Quellen, zum Beispiel Pulsenergie, Pulsrate, Pulsform usw. Bei der Zuordnung der Quellen werden solche gewählt, welche am erfolgversprechendsten sind, um die Bedrohung zu bekämpfen, zum Beispiel Quellen, die solche HPEM-Pulse aussenden, für welche die Bedrohung gemäß ihrer HPEM-Charakteristiken besonders empfindlich ist.

Insbesondere eignet sich die Wirkanordnung zur Bekämpfung einer Bedrohung durch gleichzeitig mehrere Ziele, wobei die mehreren Ziele zum Beispiel einen Schwarm von Drohnen darstellen. Jede der Drohnen ist dabei eines der Ziele. Mit anderen Worten wird in der erfindungsgemäßen Wirkanordnung bzw. deren Steuereinrichtung erfindungsgemäß ein Verfahren ausgeführt, wie es weiter unten nochmals erläutert wird.

Gemäß der Erfindung ergibt sich somit insbesondere ein skalierbares HPEM Wirkmodul. Es ergibt sich insbesondere ein HPEM-Verfahren und -System (Wirkanordnung) zur simultanen Bekämpfung multipler elektronischer Targets (z.B. UAS - unmanned aerial system, Mini-UAS-Schwärme, C4I - command, control, communications, computers, intelligence). Durch Abstimmung, Synchronisation und geeignete Ansteuerung eines / mehrerer Module / Submodule können gleichzeitig unterschiedliche Targets (Ziele) an unterschiedlichen Orten mit unterschiedlichen Frequenzen und Beams bekämpft werden. Es ergibt sich insbesondere ein halbleiterbasiertes, voll integriertes Modul, das Skalierung und Abstimmbarkeit ermöglicht.

In einer bevorzugten Ausführungsform ist wenigstens eine der Zielklassen eine solche, die auf eine Empfindlichkeit des Ziels gegenüber HPEM-Pulsen abgestimmt ist. Mit anderen Worten definiert die Zielklasse dann verschiedene Ziele, die in Bezug auf HPEM-Pulse unterschiedlich empfindlich sind. Dies ermöglicht es, die Quellen unterschiedlich anzusteuern, um die jeweilige Empfindlichkeit bestmöglich auszunutzen und die Ziele möglichst effektiv zu bekämpfen.

In einer bevorzugten Ausführungsform weist die Wirkanordnung wenigstens ein Modul auf. Jedes der Module enthält wenigstens eine der Quellen. Betreffende Quellen sind also in Modulen, insbesondere mehreren Modulen organisiert. Die Module sind zum Beispiel in Form von baulichen Einheiten ausgeführt. Die Wirkanordnung kann damit zum Beispiel besonders einfach skaliert werden, indem Module entfernt oder hinzugefügt oder ausgetauscht werden.

In einer bevorzugten Variante dieser Ausführungsform ist wenigstens eines der Module als halbleiterbasiertes vollintegriertes Modul ausgeführt. Dies ermöglicht eine besonders flexible Ansteuerung des Moduls bzw. von mehreren Quellen innerhalb des Moduls, insbesondere deren wahlweise Verschaltung zu Submodulen, siehe unten.

In einer bevorzugten Variante dieser Ausführungsform enthält wenigstens eines der Module wenigstens zwei der Quellen. Diese Quellen sind dann in Form eines Arrays in fester Relativlage zueinander angeordnet. Derartige Arrays eignen sich insbesondere, um dessen Quellen zeitlich bzw. phasenzusynchronisieren, um zum Beispiel gleichphasig eine konstruktive Überlagerung zur Leistungsverstärkung oder kontrolliert phasenversetzt eine Überlagerung zur Strahlausrichtung (Beam Steering) zu ermöglichen.

Erfindungsgemäss enthält die Wirkanordnung wenigstens drei Quellen. Diese drei oder mehr Quellen sind dann wahlweise und veränderbar zu Submodulen von je wenigstens zwei Quellen zusammenfassbar. Die Steueranordnung ist dazu eingerichtet, die als aktuelles Submodul (aktuell) organisierten Quellen gemeinsam und unabhängig von anderen Quellen anzusteuern. Insbesondere erfolgt ausschließlich jeweils eine gemeinsame Ansteuerung aller Quellen des Submoduls. Dies geschieht zum Beispiel nach einer das Submodul betreffenden Gruppenvorschrift für die Gruppe von Quellen des Submoduls. So können je nach Bedarf verschiedenartige und / oder eine verschiedene Anzahl von Quellen organisatorisch zum Submodul zusammengefasst werden, um individuell auf eine jeweilige Bedrohung zu reagieren. So können beispielsweise in einem Modul mit neuen Quellen alle neuen Quellen synchron als einziges Submodul betrieben werden, um ein einziges HPEMunempfindliches Ziel zu bekämpfen. In einer anderen Situation werden die selben neuen Quellen zu drei Submodulen mit je drei Quellen organisiert, um drei empfindlichere Ziele (weniger Quellen nötig) durch je eines der Submodule gleichzeitig zu bekämpfen.

Für eine bevorzugte Ausführungsform geht die Erfindung davon aus, dass die Bedrohung wenigstens zwei Ziele enthält. Bzw. ist die entsprechende Ausführungsform zur Bekämpfung derartiger Bedrohungen besonders geeignet. Die Steuereinrichtung ist dazu eingerichtet, die Wirkanordnung für wenigstens zwei der Ziele parallel und unabhängig voneinander zu betreiben. Die Erfindung geht also davon aus, dass auch Bedrohungen mit mehreren Zielen bekämpft werden sollen, wobei die Abwehr bzw. Bekämpfung der Ziele gleichzeitig stattfinden soll. Durch den parallelen unabhängigen Betrieb ist dies möglich. Insbesondere wird für jedes Ziel eines der oben genannten Submodule gewählt, wobei die Submodule je nach Art und Empfindlichkeit der Ziele aus den verfügbaren Quellen zusammengestellt werden. Hierdurch ist eine simultane Bekämpfung multipler Targets / Ziele möglich. Jedes der Ziele ist individuell bekämpfbar.

In einer bevorzugten Ausführungsform ist die Steuereinrichtung dazu eingerichtet, wenigstens zwei der Quellen dadurch anzusteuern, dass diese miteinander zur Aussendung der HPEM-Pulse synchronisiert werden. Insbesondere geschieht dies, wie oben bereits erläutert, innerhalb eines Submoduls. Synchronisierung ist, wie ebenfalls oben erläutert, zum Beispiel gleichphasiger Betrieb zur Fernfeld-Verstärkung (Überlagerung) oder auch phasenversetzter Betrieb zum Beam Steering.

In einer bevorzugten Ausführungsform enthält die Steuereinrichtung eine KI Einrichtung oder ist als KI Einrichtung ausgeführt (Künstliche Intelligenz). Durch Methoden der KI, die hier in fachüblicher Weise eingesetzt werden können, ist es möglich, insbesondere Wirkanordnungen mit einer Vielzahl von Quellen optimal zum Beispiel in Submodule aufzuteilen, um eine Bedrohung mit einer Vielzahl von Zielen parallel und effektiv abzuwehren.

Die Aufgabe der Erfindung wird auch gelöst durch ein Verfahren gemäß Patentanspruch 10. Das Verfahren dient zur Bekämpfung der Bedrohung in Form wenigstens eines Ziels mit Hilfe der erfindungsgemäßen Wirkanordnung. Bei dem Verfahren wird wenigstens eine Missionsvorgabe und / oder wenigstens eine Priorisierung von Zielen in Bezug auf die Bekämpfung der Bedrohung bereitgestellt. Die Steuereinrichtung ordnet der Bedrohung wenigstens eines von mehreren vorgebbaren Bedrohungsszenarien zu, ordnet der Bedrohung wenigstens eine von mehreren vorgebbaren Ziel-Klassen zu, ordnet der Bedrohung abhängig von den zugeordneten Bedrohungs-Szenarien und / oder den zugeordneten Ziel-Klassen wenigstens eine von mehreren vorgebbaren HPEM-Charakteristiken zuordnet. Die Steuereinrichtung ordnet der Bedrohung abhängig von den zugeordneten Bedrohungs-Szenarien und / oder den zugeordneten Ziel-Klassen und / oder den zugeordneten HPEM-Charakteristiken wenigstens eine der HPEM-Quellen zu.

Die Steueranordnung steuert dann zur Bekämpfung der Bedrohung die zugeordneten HPEM-Quellen an. Dies geschieht abhängig
- einerseits von den zugeordneten Bedrohungs-Szenarien und / oder den zugeordneten Ziel-Klassen und / oder den zugeordneten HPEM-Charakteristiken,
- und andererseits abhängig von den Missionsvorgaben und / oder den Priorisierungen.

Das Verfahren und zumindest ein Teil dessen möglicher Ausführungsformen sowie die jeweiligen Vorteile wurden sinngemäß bereits im Zusammenhang mit der erfindungsgemäßen Wirkanordnung erläutert.

Die Erfindung beruht auf folgenden Erkenntnissen, Beobachtungen bzw. Überlegungen und weist noch die nachfolgenden bevorzugten Ausführungsformen auf. Diese Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und / oder gegebenenfalls auch bisher nicht erwähnte Ausführungsformen einschließen.

Die Erfindung beruht auf der Idee, ein HPEM-Verfahren und -System (Wirkanordnung) zur simultanen Bekämpfung einer Bedrohung in Form multipler elektronischer Targets (Ziele, z.B. UAS, Mini-UAS Schwärme, C4I, IED) in unterschiedlichen Szenarien zu schaffen. Es soll die gleichzeitige Bekämpfung mehrerer gleicher und / oder unterschiedlicher Targets möglich sein, die sich an unterschiedlichen Orten innerhalb der Wirkreichweite (z.B. Luft (UAS, UAS-IED) und Bodenziel (z.B. IED, C4I) befinden. Es soll ein abstimmbares, synchronisierbares, halbleiterbasiertes HPEM-Modul und - System geschaffen werden, das es ermöglicht, simultan unterschiedliche Frequenzen mit gleichen und / oder unterschiedlichen Bandbreiten und gleichen und / oder unterschiedlichen Impulsen und Feldstärken gemeinsam und / oder auch separiert auf gleiche und / oder ähnliche und / oder auch unterschiedliche Targets, die sich am gleichen und / oder auch an unterschiedlichen Orten (z.B. Boden / Luft; C-UAS & C-IED Szenario) in gleichen und / oder unterschiedlichen Abständen befinden können, zu erzeugen, abzustimmen, zu synchronisieren und zielgerichtet gegen die Bedrohung zu richten / wirken.

Geschaffen wird daher insbesondere ein HPEM-Verfahren und / oder vollständig halbleiterbasiertes modulares, skalierbares System und Module mit entsprechenden Fähigkeiten: Nämlich mit leistungsstarken HPEM Impulsen (100erte MW-GW) mehrere unterschiedliche Ziele unterschiedlicher Targetklassen mit unterschiedlichen Empfindlichkeiten an unterschiedlichen Orten und in unterschiedlichen Szenarien gleichzeitig bekämpfen zu können.

Gemäß der Erfindung ergibt sich ein Verfahren und System (Wirkanordnung) zur simultanen Abwehr und Bekämpfung multipler, gleicher und unterschiedlicher elektronischer Bedrohungen und Targets (Ziele, z.B. UAS, Mini-UAS-Schwärme, C4I). Das System enthält / besteht aus einem oder mehreren gleichen und / oder gleichartigen und / oder unterschiedlichen synchronisierbaren und / oder abstimmbaren Quellen, insbesondere in Form von Modulen. Die Abstimmung mehrerer Module und / oder Submodule ermöglicht die gleichzeitige Abstrahlung identischer, ähnlicher und / oder unterschiedlicher Frequenzen, Frequenzbereiche, Mittenfrequenzen und Beams. Die Phasensteuerung der halbleiterbasierten Systeme im sub-ns-Bereich ermöglicht die Ausrichtung der Beams aus einem und / oder mehreren (Sub-)Modulen / Quellen auf ein und / oder mehrere gleiche, gleichartige und / oder unterschiedliche Targets, Targetklassen oder Targetgruppen.

Durch die halbleiterbasierte Modul- und Submodulbauweise ist das System skalierbar und abstimmbar. Das Verfahren kann auf unterschiedliche Szenarien skaliert / abgestimmt / angepasst werden. Das Modul / Module / System kann zentral gesteuert, ferngesteuert und / oder mittels KI autonom / teilautonom die Bekämpfung eines oder mehrere Targets steuern bzw. in die Wege leiten. KI liefert dabei einen wesentlichen Beitrag zur effizienten, zielgerichteten Steuerung der verschiedenen Komponenten, Sub-Module, Module und Systeme. Dies betrifft sowohl die Identifikation und Klassifikation der Bedrohung sowie die Auswahl und das zielgerichtete Bekämpfen der Bedrohungen wie auch die wirkoptimierte Steuerung der Einzelsysteme / - komponenten / -module wie auch mehrerer Systeme und Module.

Durch übergeordnete Steuerung mittels KI können mehrere gleiche und / oder unterschiedliche Module / Submodule / Systeme (Wirkanordnungen) und Komponenten ausgewählt, kombiniert und koordiniert gegen einzelne und / oder mehrere Ziele gleiche / gleichartige / ähnliche und / oder unterschiedliche Targets / Targetgruppen und Targetklassen in gleichen und unterschiedlichen Szenarien sequenziell und / oder gleichzeitig gesteuert und wirkoptimiert eingesetzt werden.

Es ergibt sich ein Verfahren und System zur simultanen Abwehr unterschiedlicher elektronischer Bedrohungen basierend auf einem bzw. mehreren halbleiterbasierten, synchronisierbaren und auf die Bedrohung abstimmbaren, skalierbaren HPEM-(Wirk-)Modulen.

Es ergibt sich ein halbleiterbasiertes, modulares vollständig integrierbares / integriertes HPEM-Wirkmodul / System. Jedes Modul umfasst sowohl die Energieversorgung inkl. Energiezwischenspeicherung und -aufbereitung, die Steuerung, die Phasensteuerung und Synchronisation der Sub-Module und Verschaltung der Antennen inkl. Einspeisenetzwerk. Die Abmessungen und geometrischen Formen der Module können dabei entsprechend sinnvoller / möglicher Integrationsmöglichkeiten bzw. Anwendungsfällen unter Anbetracht der abzustrahlenden Frequenzen / Frequenzbereiche, sowie der Dimensionierung der Antennenelemente / der Antenne und damit der Wirkung resultieren. So sind beispielsweise quaderförmige Module mit Antennenelementen z.B. auf einer (oder mehrerer) der Längsseiten, aber auch zylinderförmige Module mit den abstrahlenden Elementen auf z.B. einer oder beiden Zylindergrundflächen, aber auch viele andere Kombinationen sinnvoller Geometrien und Abmessungen denkbar. Die Antenne / Antennenelemente jedes Moduls / Submoduls bestehen aus mindestens einem und / oder mehreren Antennenelementen (z.B. Monopol, Dipol, Patchantenne, Antennenstrukturen mit Metamaterialien, aktiven und / oder passiven Steuerelementen in den Antennenelementen oder anderen geeigneten Konfigurationen) die abhängig von der zu erzielenden bzw. erforderlichen abgestrahlten Leistung und den abzustrahlenden Frequenzen / Frequenzbereichen, miteinander gekoppelt, verkoppelt oder verschaltet, mit passiven und / oder aktiven Elementen / Steuerungselementen / Abstimmungselementen passiv oder auch aktiv betrieben werden können. Das aktiv- und / oder passiv-Schalten einzelner und / oder von Elementen / Steuerungselementen / Abstimmungselementen ist möglich.

Durch die gezielte Beeinflussung / Steuerung / Verschaltung einzelner / mehrerer, gleicher und / oder gleichartiger und / oder unterschiedlicher Antennenelemente und / oder Antennenstrukturen und / oder aktiver / passiver Elemente in den Antennenstrukturen und der entsprechenden Ansteuerung über KI, ist es möglich, einzeln und / oder simultan unterschiedliche Antennenkonfigurationen und damit unterschiedliche abgestrahlte Pulsformen und Wellenlängen mit unterschiedlichen abgestrahlten Bandbreiten in einem einzigen Modul zu realisieren. Der Abstand der einzelnen Antennenelemente und / oder -strukturen muss dabei weder modulintern noch modulübergreifend uniform bzw. linear sein. Beispielsweise können Oberwellen bzw. Resonanzen, also Multibanddesign in den einzelnen Antennenelementen in Verbindung mit dem Ansprechen von Arrayspalten oder -zeilen unterschiedlichen geometrischen Abstands in Abhängigkeit von den benötigten Abstrahleigenschaften und der Abstrahlfrequenz gewählt wenden. Durch den Betrieb und die geeignete Verschaltung mehrerer Module / Teil(Sub-)module in einem System kann die Betriebsart und der Betriebsmodus zusätzlich erweitert werden. Der Betrieb mehrerer Module in einem Array ist möglich. Die Module können jeweils separat und / oder in Gruppen oder als Gesamtes betrieben werden. Durch gezielte Synchronisation und Beeinflussung der Phasenlage zwischen den unterschiedlichen abgestrahlten Frequenzen, Mittenfrequenzen, Wellen und / oder Impulsen können die HPEM-Strahlen fokussiert und die Reichweite entsprechend skaliert, erhöht und angepasst werden. Durch die exakte zeitliche Synchronisation der halbleiterbasierten Elemente in einem Modul, in mehreren Modulen, Gruppen und Systeme im sub-ns und ps-Bereich (auch sub-ps möglich) ist das Verfahren skalierbar und auch auf räumlich verteilte Systeme übertragbar (Distributed Modules, Arrays and Systems). Zudem lässt sich durch die exakte zeitliche Synchronisation ein Beam Steering zur Bekämpfung und Nachverfolgung von Zielen einfach realisieren.

Die Steuerung und Ansteuerung der einzelnen Antennenelemente / Antennen / Antennenmodule und Sub-Systeme wie auch der einzelnen / mehrerer HPEM-Module / -Submodule und -Systeme erfolgt über eine integrierte und / oder übergeordnete Kl. Dadurch kann / können die jeweilige Modul- und Antennenkonfigurationen, die abgestrahlten Frequenzen / Frequenzbereiche und Pulsformen auf die jeweiligen Targets / Targetklassen und / oder Targetgruppen einzeln oder auch in Kombination miteinander angepasst und die Wirkung effizient gesteigert werden. Die abgestrahlten Pulsformen, Frequenzen und Bandbreiten können damit auf das Zielspektrum wie auch auf die Wirkung und Wirkreichweite gezielt angepasst werden. Die Ausrichtung der HPEM Strahlen einzeln und / oder in Gruppen kombiniert ist möglich.

Unter Berücksichtigung einer Sensorikeinheit, einer Trackingeinheit und einer Steuereinheit zum Abgleich und der Nachführung der Strahlausrichtung (elektronisches Beam Steering) kann / können das / die Targets im Zielstrahl gehalten und über längere Zeit beaufschlagt werden. Durch Gruppierung und Verschaltung unterschiedlicher Teilbereiche eines Moduls oder mehrerer Submodule oder auch Module können gleichzeitig auch mehrere unterschiedliche Beams mit identischen und / oder auch unterschiedlichen Frequenzen / Frequenzbereichen / Bandbreiten und Pulscharakteristika auf dasselbe Target (z.B. Einzeltarget oder Schwarm) gerichtet und bekämpft werden. Durch die hohe Flexibilität in der Beschaltung der einzelnen Antennenelemente, Antennengruppen und Module und die exakte zeitlich Abstimmung und Synchronisation untereinander, die über KI ausgewählt und gesteuert wird, können auch simultan mehrere Beams auf mehrere gleiche und / oder unterschiedliche Targets am selben und / oder auch unterschiedlichen Orten gerichtet werden. Hierfür ist eine exakte zeitliche Steuerung und entsprechend kleiner zeitlicher Jitter erforderlich, der mit anderen Technologien nicht realisierbar ist. Die Ziele müssen sich im möglichen Schwenk- und Wirkbereich des / der HPEM Strahls / Strahlen bzw. des / der Moduls / Module bzw. des / der Systems / Systeme befinden.

Es ergibt sich ein autarkes / autonomes / teilautonomes oberflächenkonform integrierbares, skalierbares, vollständig halbleiterbasiertes HPEM Wirkmodul für unterschiedliche Trägerplattformen (Land, Luft, See) für z.B. MGCS (Main Ground Combat System) und FCAS (Future Combat Air System).

Die Erfindung hat den Vorteil, dass sich ein HPEM-Verfahren und -System zur simultanen Bekämpfung multipler elektronischer gleicher / gleichartiger und / oder unterschiedlicher Targets (z.B. UAS, Mini-UAS-Schwärme, C4I, IED) in gleichen / ähnlichen und / oder unterschiedlichen Szenarien an gleichen / ähnlichen und / oder unterschiedlichen Orten ergibt.

Es ergibt sich ein halbleiterbasiertes vollständig integriertes, autarkes und / oder autonomes, modulares, abstimmbares, Kl-gesteuertes skalierbares HPEM Wirksystem / Modul zur gleichzeitigen und / oder sequenziellen Bekämpfung mehrerer unterschiedlicher und / oder gleicher elektronischer Targets / Targetklassen und / oder Targetgruppen, die unterschiedliche Empfindlichkeiten und unterschiedliche empfindliche Frequenzen und / oder empfindliche Spektralbereiche aufweisen können.

Es ergibt sich ein halbleiterbasiertes HPEM Wirk-Modul und System zur gleichzeitigen gesteuerten und / oder autarken und / oder autonomen Abwehr und Bekämpfung von unterschiedlicher Targets (z.B. UAS, Mini-UAS, Mini-UAS-Schwärme, C4I) die sich nahe beieinander und / oder auch an unterschiedlichen Orten in gleichen und / oder unterschiedlichen Wirkreichweiten / Abständen befinden können (z.B. gleichzeitige Bekämpfung von Schwarm-Zielen und Einzelzielen; Luftzielen und / oder bodennahen Zielen ö.ä.). Die Ziele können gleiche und / oder ähnliche und / oder unterschiedliche empfindliche Frequenzen und / oder Frequenzbereiche / Spektralbereiche / Mittenfrequenzen aufweisen. Durch die halbleiterbasierte modulare, teil- und / oder vollintegrierte Bauweise soll das Modul / System skalierbar und auf unterschiedliche Anforderungen aus unterschiedlichen Anwendungen und Szenarien leicht adaptierbar, anpassbar und abstimmbar und skalierbar sein. Die elektronische Abstimmung der aktiven / passiven Antennen / -elementen / -strukturen und die Abstimmung mehrerer Module / Submodule / Systeme ermöglicht es gleichzeitig und / oder sequenziell unterschiedliche Targets mit gleichen / ähnlichen und / oder auch unterschiedlichen Frequenzen und HPEM Impulsen und HPEM-Beams zu beaufschlagen bzw. zu bekämpfen. Durch die modulare halbleiterbasierte Bauweise und entsprechende Ansteuerung ist auch die Ausrichtung mehrerer und / oder unterschiedlicher Beams auf ein und / oder mehrere Ziele gleicher, gleichartiger und / oder ungleicher Art möglich. Das / die Modul / -e und / oder System / -e ist / sind skalierbar und auf das / die Target / -s und das / die Szenario / -en abstimmbar / anpassbar / skalierbar. Der Betrieb kann autark, autonom, ferngesteuert, über internen / externen Timer / Mastertimer und / oder mit Man in the Loop (MIL) oder auch manuell erfolgen. Die Steuerung über KI ermöglicht eine aktiv gesteuerte Anpassung der Module und Systeme an die jeweiligen aktuellen und sich aktuell ändernden Anforderungen aus dem Targetspektrum und den Szenarien in "Echtzeit".

Die Erfindung eignet sich für:
1. HPEM System stationär oder auf mobilen Plattformen für verschiedene Anwendungen (z.B. für Counter-UAS als Fahrzeugschutz, C-UAS Feldlagerschutz, CIED etc.)
2. HPEM System mobil für Land-Anwendung integriert auf einem Fahrzeug zum Eigenschutz im Rahmen NNbS (Nah- und Nächstbereichsschutz) und MGCS (Main Ground Combat System) für verschiedene Anwendungen (z.B. Counter-UAS, C-IED, Konvoi-Schutz etc.)
3. HPEM System mobil für Luft- und See-Anwendung integriert auf einem Flugzeug, Drohne oder Schiff zum Eigenschutz im Rahmen NNbS für verschiedene Anwendungen (z.B. Counter-UAS, C-IED, BootStop etc.)
4 Verteilte HPEM-Module und / oder Systeme mit Schwarmfähigkeit (z.B. UAS, Drohnen) für koordinierte Aktionen zum Schutz oder für Attack. Integration auf mobilen und / oder fliegenden Plattformen (z.B. FCAS, NGF, LW, RC, UAV, UAS, Mini-UAS etc.)

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen, jeweils in einer schematischen Prinzipskizze:
- Figur 1: den Grundaufbau einer erfindungsgemäßen Wirkanordnung in symbolischer Schrägansicht,
- Figur 2: eine alternative Wirkanordnung mit Versorgungselementen in Draufsicht,
- Figur 3: und in Frontansicht mit exemplarischen Quellen,
- Figur 4: eine alternative Wirkanordnung bei der Bekämpfung einer Bedrohung in verschiedenen, auch Detailansichten,
- Figur 5: ein alternatives Einsatzszenario einer Wirkanordnung an einem Flugzeug,
- Figur 6: ein alternatives koordiniertes Einsatzszenario mehrerer Wirkanordnung,
- Figur 7: ein Ablaufdiagramm eines erfindungsgemäßen Verfahrens.

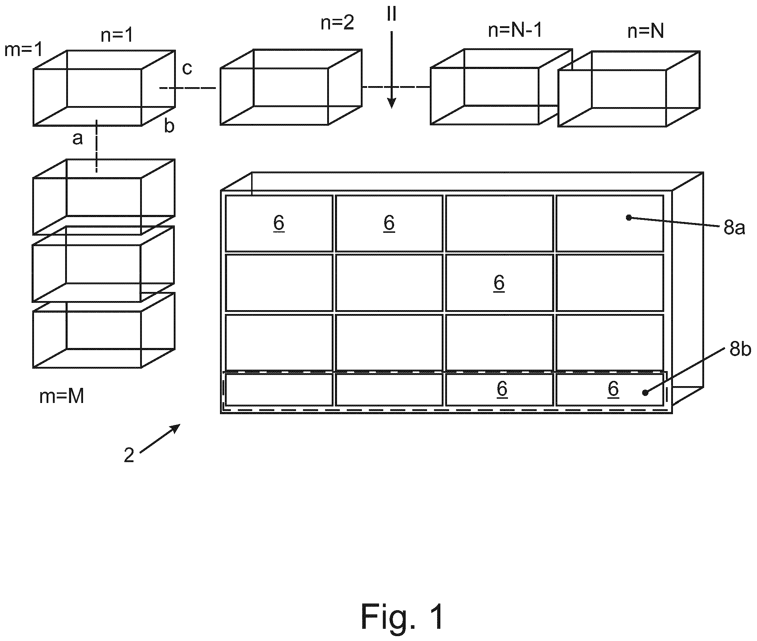

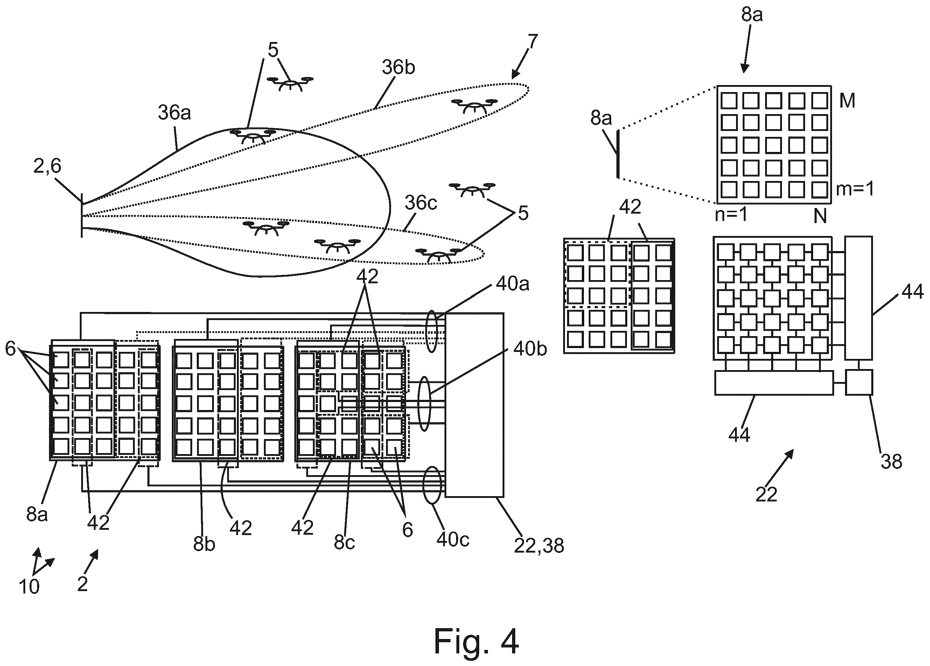

Figur 1 zeigt eine autarke, autonome, skalierbare Halbleiter-HPEM Wirkanordnung 2 zur Abwehr bzw. Bekämpfung einer gegnerischen elektronischen Bedrohung 4 (siehe Figur 4). Die Wirkanordnung 2 enthält im Beispiel sechzehn HPEM Quellen 6, die in Spalten n=1,2,...N und Reihen M=1,2,...M, also als NxM-Array 10, angeordnet sind (symbolisch auch für den allgemeinen Fall angedeutet).

Die Wirkanordnung 2 ist hier zu insgesamt zwei Modulen 8a,b (auch "Wirkmodulen") organisiert, die auch als Basismodule bezeichnet werden können. Das Modul 8a enthält zwölf Quellen 6, angeordnet in einem 4x3-Array. Das Modul 8b enthält vier Quellen 6 in Form eines 4x1-Arrays 10. Somit ergibt sich die Wirkanordnung 2 als HPEM-Modul-Array mit zwei unterschiedlichen (Basis-) Modulen 8a,b. Das Modul 8b ist zur Abgrenzung gegenüber dem Modul 8a durch einen angedeuteten Rahmen gekennzeichnet.

Die Dimensionen a,b,c jeder Quelle 6 sind eine Funktion verschiedener Parameter wie Frequenz, Bandbreite, Anzahl und Dichte der Elemente, Permeabilitätszahl und Permittivitätszahl. Die Auslegung der Dimensionen die ist abhängig bzw. bestimmt durch die zu realisierenden abzustrahlen Frequenzen, Pulse, Feldstärken, Bandbreiten und Materialeigenschaften (zum Beispiel Brechungsindices, Metamaterialien etc.).

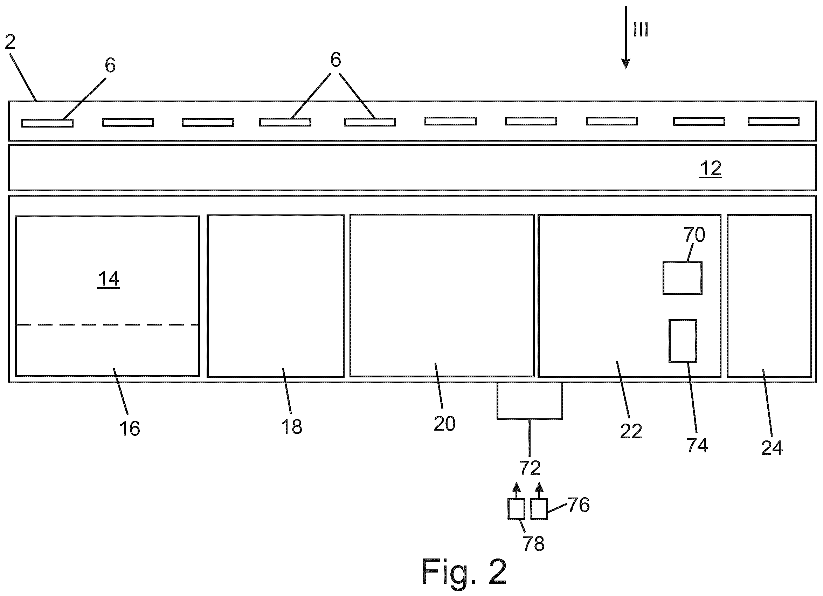

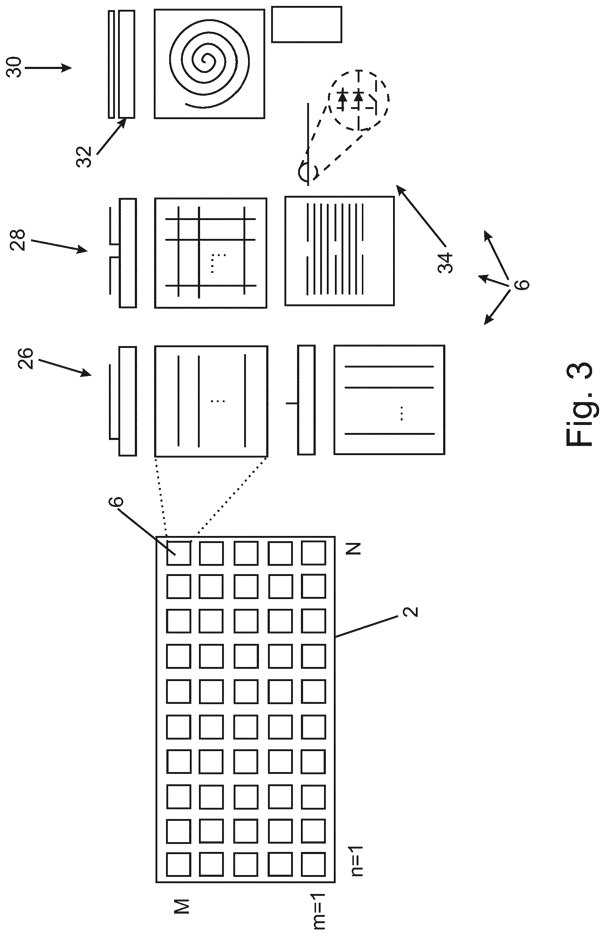

Figur 2 und Figur 3 zeigen eine alternative Wirkanordnung 2 als 10x5-Array 10. Figur 2 zeigt eine Draufsicht, vergleichbar der Richtung des Pfeils II in Figur 1. Die Quellen 6 sind hier in Form von N=10 Antennenelementen angedeutet. Die Quellen 6 bilden in ihrer Gesamtheit eine Art Front Panel, welches nur die Antennenelemente in Form der Quellen 6 beinhaltet. Figur 2 zeigt auch weitere Komponenten, die zur Versorgung der Wirkanordnung 2 vorhanden sind:
Ein Speisenetzwerk 12 erfüllt auch den Zweck einer Leistungsteilung. Eine Energieversorgung 14 ist gespeist aus Primärenergie 16. Ein Puffer 18 dient zur Energiezwischenspeicherung und Aufbereitung. Ein Block 20 enthält insbesondere die Halbleiter HPEM- / HV-Generatoren zur Versorgung der Quellen 6. Eine der Wirkanordnung 2 zugehörige Steuereinrichtung 22 dient zur Steuerung und Synchronisierung der Quellen 6. Ein Block 24 enthält Interfaces bzw. Schnittstellen.

Figur 3 zeigt die Frontansicht der Wirkanordnung 2 aus Figur 2 in Richtung des Pfeils III in Figur 2, also das oben genannte Frontpanel mit den Quellen 6 in Form von Antennenelementen. Für eine der Quellen 6 sind (angedeutet durch gestrichelte Linien) mögliche Ausführungsformen der Quellen 6 in Form von Antennenbasiselementen dargestellt. Lediglich beispielhaft können dies sein: Monopole 26, Dipole 28 oder Spiralantennen 30. Diese können insbesondere aufweisen (angedeutet durch den Pfeil 32): Reflektoren / Absorber / Metamaterial mit passiven / aktiven Elementen, deren Eigenschaften ansteuerbar / einstellbar sind. Enthalten können sein (angedeutet durch den Pfeil 34, nur Beispiele): Elektronische und / oder mechanische Elemente / Bauelemente / Schaltelemente / Metamaterial zur Auswahl / Steuerung von Frequenz, Bandbreite, Richtcharakteristik, Abstrahlverhalten.

Insgesamt sind die Quellen 6 charakterisiert durch:
- Aktive / passive Elemente für Zu- / Abschaltung / Ansteuerung, Abstimmung und Tuning des Frequenzbereichs und der Bandbreite.
- Anzahl, Abstand und Dimensionierung abhängig von der zu realisierenden Frequenz und Bandbreite
- Antennenelemente zu- und abschaltbar, kombinierbar zu Gruppenelementen

Die Figuren 2 und 3 in Zusammenschau zeigen also ein halbleiterbasiertes HPEM Wirkmodul (Basismodul) in Form der Wirkanordnung 2 und Ausführungsbeispiele für die Antennen-Basiselemente. Hierfür ergeben sich folgende Eigenschaften:
- Beam Steering Fähigkeit.
- Multi-Beam und Multi-Frequenz Fähigkeit (unterschiedliche Strahlen und / oder Frequenzen, unterschiedliche Ausrichtungen - simultan und / oder zeitlich synchronisiert / abgestimmt aufeinander abgestimmt). Fokussierung und Abstimmung auf das Target, Abstimmung Frequenz und / oder Pulsform (Anstiegszeit, Dauer, Schwingverhalten, Energie, Leistung etc.) und / oder Amplitude)).
- Antennenelement einzeln ansteuerbar.
- Bestehend aus z.B. Mono-, Dipol-, Spiralantenne.
- mit / ohne Metamaterial.
- Kommunikation I/O
- Synchronisation
- vollständig integriert in einem Modul
- Synchronisation mehrerer Module
- HPEM Impulse UWB, WB, NB
- Spannungen im Bereich einiger kV bis MV
- Leistung einige MW bis GW Gesamtleistung
- Patch-Antenne, Monopol, Dipol, dielektrische Linse
- Metamaterial Linse
- Multiple Beams innerhalb einer Apertur-Fläche
- gleichzeitig Abwehr multipler Bedrohungen (z.B. C-UAS, C-IED, C4ISTAR-Targets).

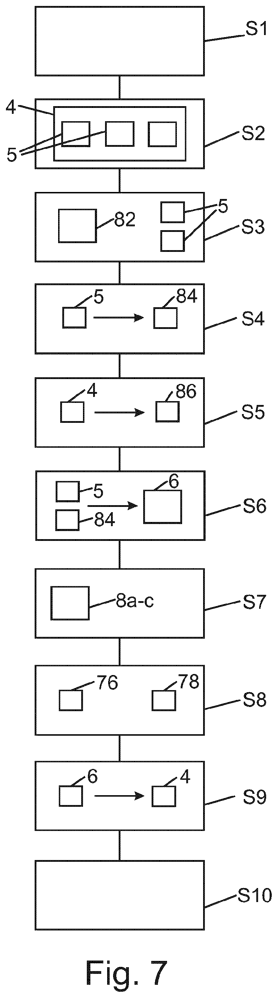

Figur 2 zeigt auch symbolisch, dass in der Steuereinrichtung 22 ein Verfahren 70 (siehe Figur 7) ausgeführt wird. Symbolisch ist auch angedeutet, dass die Wirkanordnung 2 einen Eingang 72 und einen Speicher 74 aufweist, um eine Missionsvorgabe 76 für die Bekämpfung der Bedrohung 4 sowie eine Priorisierung 78 der Ziele 5 der Bedrohung 4 zu empfangen bzw. zu speichern.

Figur 4 zeigt den Einsatz einer alternativen autonomen skalierbaren HPEM Wirkanordnung 2 zur Abwehr gegnerischer Elektroniken in Form der Bedrohung 4 (C-UAS, C-IED, C4I). Die Bedrohung 4 besteht hier aus insgesamt sieben Zielen 5 in Form einer jeweiligen Drohne, die als Schwarm 7 organisiert sind. Die Wirkanordnung 2 erzeugt bzw. sendet im Betrieb aus ihren Quellen 6 (hier nicht explizit gezeigt) HPEM Pulse 36a-c aus, um die Bedrohung 4 zu bekämpfen. Figur 4 links unten zeigt dabei, dass hier eine Alternative Wirkanordnung 2 zum Einsatz kommt. Diese umfasst insgesamt drei Module 8a-c, welche jeweils ein 5x5-Array 10 von Quellen 6 enthalten. Die Steuereinrichtung 22 ist hier als KI-Einrichtung 38 bzw. KI-Steuerung ausgebildet und arbeitet autonom, teilautonom, manuell oder mit Human-in-the-Ioop.

Die einzelnen Quellen 6 bzw. Antennenelemente und Module 8a-c in Form der Wirkmodule sind gruppierbar und skalierbar. In der Figur ist dies symbolisch durch 3 alternative Ansteuerung 40a-c angedeutet, welche mit ein und derselben Wirkanordnung 2alternativ zueinander ausgeführt werden können. Hierzu werden die Quellen 6 zu unterschiedlichen Submodulen 42 zusammengefasst. Zum Beispiel wird gemäß der Ansteuerung 40c im Modul 8a nur (von links gezählt) die zweite und fünfte Spalte des Arrays 10 zu je 5 Quellen angesteuert, im Modul 8b nur die dritte Spalte und im Modul 8c nur die erste und vierte Spalte. Die restlichen Quellen 6 bleiben hier ungenutzt.

Alternativ werden gemäß der Ansteuerung 40b nur im Modul 8c jeweils vier quadratisch angeordnete Quellen 6 zu 4x4-Submodul 42 zusammengefasst und nur insgesamt vier solcher Submodule gebildet.

Rechts in Figur 4 ist die Bildung von Submodulen 42 nochmals für eines der Module 8a mit 5x5 Quellen 6 angedeutet. Innerhalb diesem werden hier alternativ zwei Submodule 42 gebildet. Hier ist auch eine alternative Steuereinrichtung 22 dargestellt, die neben der KI-Einrichtung 38 zwei weitere Steuerungskomponenten 44 enthält.

Die Gruppierungen der Quellen 6 bzw. Antennengruppierungen sind hier wieder
- zuschaltbar
- abstimmbar
- können unterschiedliche Frequenzen und Frequenzbereiche aufweisen
- Ansteuerung und Synchronisation kann sowohl leitungsgebundenen als auch ferngesteuert (RC) erfolgen.

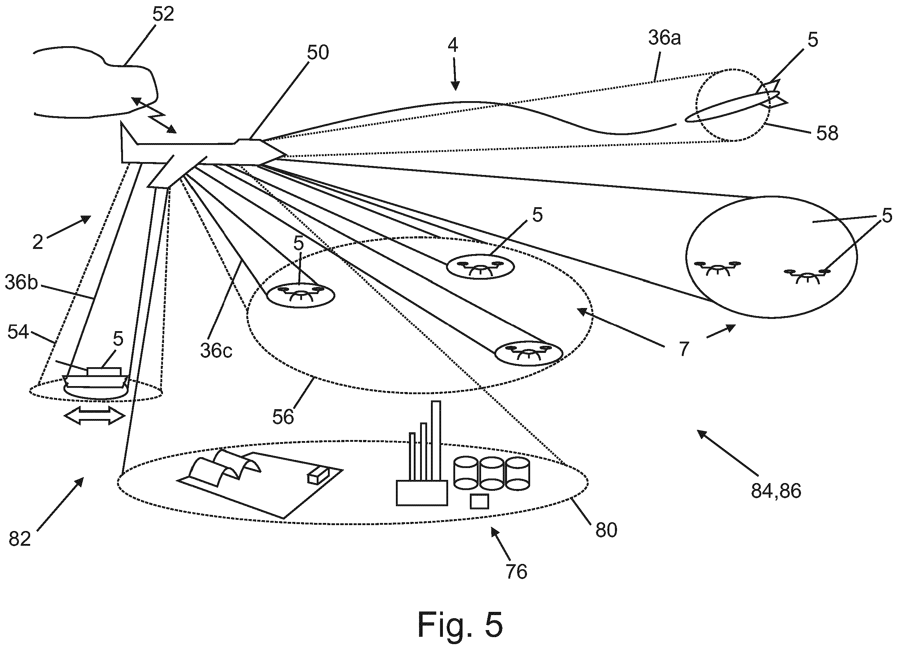

Figur 5 zeigt den Einsatz einer Wirkanordnung 2, welche an einem Flugzeug 50 angebracht und an diesem betrieben wird. Dieses steht in Verbindung mit einem Führungssystem 52, welches ebenfalls Kl-basiert arbeitet. Auch das Flugzeug 50 arbeitet KI basiert.

Für die Wirkanordnung 2 gilt:
- simultane Multi-Use Multi Role Fähigkeit
- simultane Counter-Multi-Target-Fähigkeit
- Multi-Level, Multi-Frequenz, Multi-Beam Fähigkeit, Couter-Swarm Fähigkeit
- HPEM Beam-Steering und Beam / Puls-Forming Fähigkeit
- KI (Detektion / Tracking / Identifikation) für optimale und effiziente Interoperabilität

In der Figur 5 ist dies dadurch angedeutet, dass eine Vielzahl von HPEM Pulsen 36a-c (hier nur diese drei bezeichnet) ausgesendet werden können, um die Gesamtbedrohung 4 in Form einer Reihe von Zielen 5 gleichzeitig bekämpfen zu können. Ein Erfassungskegel 54 zusammen mit einem Pfeil verdeutlicht hier die Fähigkeit zum Verfolgen und Fokussieren (Tracking und Focusing) für ein Ziel 5. Ein weiterer Kegel 56 verdeutlicht die Fähigkeit, Multiple-Beams auf mehrere Ziele 5 auszusenden (Multibeam Capability). Ein Kreis 58 verdeutlicht die Multi-Role-Fähigkeit der Wirkanordnung 2, in dem diese simultan mit der Bekämpfung von Drohnen als Ziel 5 auch andere Ziele 5, wie eine anfliegende Rakete abwehren kann.

Figur 5 symbolisiert auch eine Missionsvorgabe 76 für die Wirkanordnung 2 im augenblicklichen Einsatz, nämlich den Schutz einer eigenen Industrieanlage 80 vor der Bedrohung 4.

Figur 5 illustriert auch ein Bedrohungsszenario 82. Dieses charakterisiert, welcher Art die Bedrohung 4 ist, welche und wie viele Ziele 5 beteiligt sind usw. ebenso erfolgt eine Auswahl und Zuordnung der Ziele 5 bzw. Gruppen von Zielen 5, zum Beispiel Schwärme 7, welche zu bekämpfen sind. Vorliegend handelt es sich also um einen Angriff auf die Industrieanlage 80 durch einen Drohnenschwarm und gleichzeitig einen Angriff auf das Flugzeug 50 durch eine Rakete.

Ebenso sind hier zwei Zielklassen 84 detektiert, nämlich eben "Drohnenschwarm" und "Rakete" für die entsprechenden Ziele 5. Eine HPEM-Charakteristik 86 der Bedrohung 4 bzw. der Ziele 5 ist daher bekannt, da bekannt ist, auf welche Art von HPEM-Pulsen 36 die Ziele 5 empfindlich sind und wie viele hiervon nötig sind, um die Ziele 5 erfolgreich zu bekämpfen, also auszuschalten.

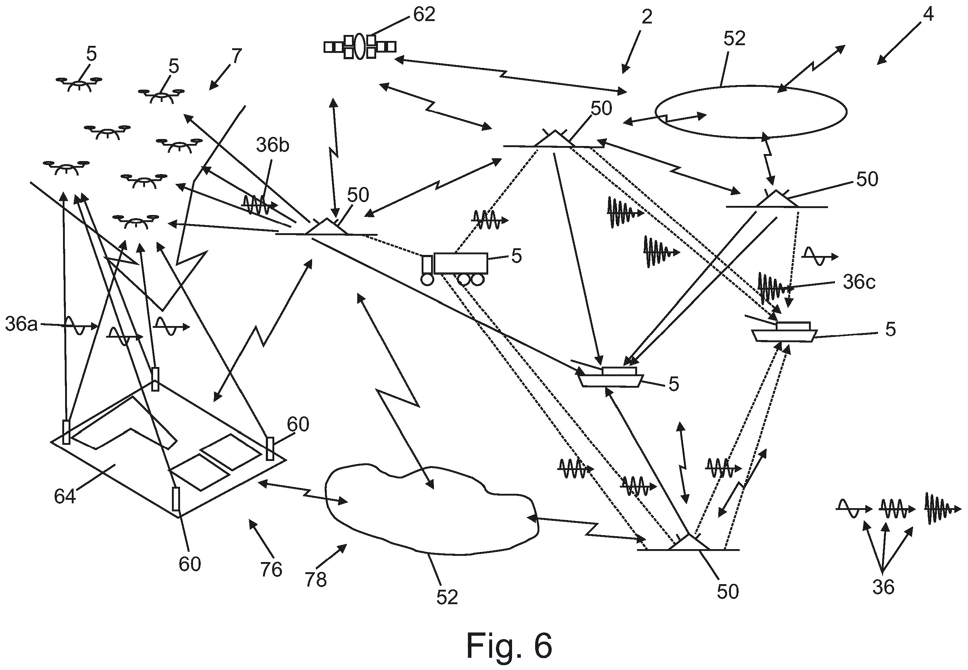

Figur 6 zeigt in einem weiteren Einsatz-Szenario, wie mehrere Wirkanordnungen 2, auf verschiedenen Plattformen, nämlich vier Flugzeugen 50 sowie stationären Objekten 60, hier Abwehrstationen einer eigenen Stellung 64 (Feldlager, mil. Einrichtung C4) angebracht sind und zusammenarbeiten, um eine massive Bedrohung 4 mit verschiedensten Zielen 5 wie einem Panzer, einem weiteren Fahrzeug und einem UAS-Schwarm 7 zu bekämpfen.

Hierbei sind auch zwei Führungssysteme 52 zur Koordination der Wirksysteme 2 beteiligt sowie eine Unterstützung durch einen Satelliten 62 in Form von GPS Daten. Wie in Figur 5 ist eine jeweilige Kommunikation durch einen blitzartigen Doppelpfeil symbolisiert.

Die Führungssysteme 52 übernehmen hierbei die Koordination / Zielzuweisung und Steuerung. Verschiedene HPEM Pulse 36 sind in der Figur rechts unten durch verschiedene Wellenformen angedeutet und kommen hier synchron bzw. gleichzeitig zum Einsatz, um verschiedene Ziele verschiedener Empfindlichkeitscharakteristiken zu bekämpfen. Insbesondere werden also verschiedene HPEM Pulse, Pulsfolgen und Pulssequenzen genutzt. Die Missionsvorgabe 76 ist hier der Schutz der eigenen Stellung 64. Die Objekte 60 beschützen hierbei eine eigene Stellung bzw. ein Feldlager bzw. eine militärische Einrichtung C4.

Figur 6 erläutert auch eine Priorisierung 78: Die Priorisierung 78 besagt, zunächst das Ziel 5 in Form der anfliegenden Rakete abzuwehren und anschließend das Ziel 5 in Form des Kampfpanzers auszuschalten und erst abschließend die beiden Drohnenschwärme 7 zu bekämpfen. Anhand der Missionsvorgabe 76 und der Priorisierung 78 ergibt sich damit ein Bekämpfungsszenario, nämlich wie und in welcher Reihenfolge die Ziele 5 der Bedrohung 4 zu bekämpfen sind.

Figur 7 zeigt ein Ablaufdiagramm für ein Verfahren 70 zur Bekämpfung einer Bedrohung 4. Hierzu wird eine autonome, skalierbare, HPEM Wirkanordnung 2 (Wirkmodule) zur Abwehr gegnerischer Elektroniken (C-UAS, C-IED, C4I) genutzt:

Das Verfahren 70 beginnt mit einem Schritt S 1. im Schritt S 1 erfolgt eine Aktivierung / Wake-Up der Wirkanordnung 2, also des Systems / Elektronik / Sensorik / Steuerung.

Dabei erfolgt eine Aktivierung der Sensorik (falls diese nicht permanent aktiv ist, kann durch ein übergeordnetes System geschehen (z.B. Führungssystem 52)).

In einem Schritt S 2 erfolgt die Detektion der Bedrohung 4 bzw. der Ziele 5 sowie die Identifikation und Klassifizierung der Bedrohung 4 bzw. der Ziele 5. Ebenso beginnt eine Verfolgung (Tracking) der Ziele 5.

In einem Schritt S3 erfolgt eine Auswahl und Zuordnung der Bedrohungsszenarien 82 zu der Bedrohung 4.

In einem Schritt S4 erfolgt die Zuordnung der Bedrohung 4 bzw. der Ziele 5 zu Zielklassen 84 (Target-Klasse). Derartige Zielklassen 84 sind zum Beispiel "Drohne", "Kampfpanzer", "Rakete" usw.

In einem Schritt S5 werden der Bedrohung 4 bzw. den zu bekämpfenden Zielen 5 Empfindlichkeitsklassen in Form von HPEM-Charakteristiken 86 zugeordnet. Dies geschieht in Abhängigkeit der zugeordneten Bedrohungs-Szenarien 82 und der Zielklassen 84. Die HPEM-Charakteristiken 86 besagen, auf welche Art der Bekämpfung (Pulsanzahl, Dauer, Frequenz, Amplitude, ...) das jeweilige Ziel 5 bzw. die Bedrohung 4 empfindlich ist, so dass entsprechend geeignete HPEM Maßnahmen gewählt werden können, die in diesem Fall hohe Wirksamkeit gegen die Bedrohung 4 versprechen.

In einem Schritt S6 folgt daher die Zuordnung / Auswahl der erforderlichen / effizientesten Pulsformen und Frequenzbereiche und Bandbreiten zu den Zielen / Zielgruppen / Zielklassen 84. Somit werden die Charakteristiken festgelegt, nach welchen die Quellen 6 bzw. Module 8a-c anzusteuern bzw. zu betreiben sind.

In einem Schritt S7 erfolgt nun die Auswahl, Ansteuerung und Synchronisation der Module 8a-c / Submodule 42 (Subsysteme) /Antennen, die am besten geeignet sind, die im Schritt S 6 ermittelten Charakteristiken der Quellen 6 umzusetzen.

In den Schritten S6 und S7 erfolgt also die Zuordnung der Bedrohung 4 abhängig von den zugeordneten Bedrohungs-Szenarien 82 und den zugeordneten Ziel-Klassen 84 und den zugeordneten HPEM-Charakteristiken 86 an die HPEM-Quellen 6.

In einem Schritt S8 erfolgt die Festlegung der Missionsvorgaben 76 und Priorisierung 78 bzw. die betreffenden Entscheidungen. Diese werden dann über den Eingang 72 in die Wirkanordnung 2 eingebracht, im Speicher 74 abgelegt oder diesem entnommen. Dies entspricht bzw. geht einher mit der Auswahl von Bekämpfungsszenarien / -modi, um der Bedrohung 4 zu begegnen. Somit ist die Missionsvorgabe 76 und die Priorisierung 78 in dem Verfahren 70 bereitgestellt.

In einem Schritt S9 erfolgt die tatsächliche Ansteuerung, Einstellung und Synchronisation der Module 8a,b, Quellen 6 bzw. der Systeme. Somit findet die eigentliche Bekämpfung der Bedrohung 4, also der Ziele 5, also des / der Targets statt. Die Ansteuerung der Quellen 6 zur Bekämpfung der Bedrohung 4 erfolgt hier also abhängig von den zugeordneten Bedrohungs-Szenarien 82 und den zugeordneten Ziel-Klassen 84 und den zugeordneten HPEM-Charakteristiken 86 und den Missionsvorgaben 76 und den Priorisierungen 78.

In einem Schritt S10 erfolgt die Verifikation der Bekämpfung.

### Bezugszeichenliste

- 2: Wirkanordnung
- 4: Bedrohung
- 5: Ziel
- 6: HPEM-Quelle
- 7: Schwarm
- 8a-c: Modul
- 10: Array
- 12: Speisenetzwerk
- 14: Energieversorgung
- 16: Primärenergie
- 18: Puffer
- 20: Block
- 22: Steuereinrichtung
- 24: Block
- 26: Monopol
- 28: Dipol
- 30: Spiralantenne
- 32: Pfeil
- 34: Pfeil
- 36,36a-c: HPEM-Puls
- 38: KI-Einrichtung
- 40a-c: Ansteuerung
- 42: Submodul
- 44: Steuerungskomponente
- 50: Flugzeug
- 52: Führungssystem
- 54: Kegel
- 56: Kegel
- 58: Kreis
- 60: Objekt
- 62: Satellit
- 64: Stellung
- 70: Verfahren
- 72: Eingang
- 74: Speicher
- 76: Missionsvorgabe
- 78: Priorisierung
- 80: Industrieanlage
- 82: Bedrohungsszenario
- 84: Zielklasse
- 86: HPEM-Charakteristik

- n: Spalte
- m: Zeile
- a,b,c: Dimension
- S1-10: Schritt

## Patentansprüche

1. Wirkanordnung (2) zur Bekämpfung einer Bedrohung (4) in Form wenigstens eines Ziels (5),
- mit wenigstens zwei HPEM-Quellen (6), die dazu eingerichtet sind, jeweilige HPEM-Pulse (36a-c) auf die Bedrohung (4) hin auszusenden,
- wobei wenigstens zwei der Quellen (6) unabhängig voneinander zur Aussendung der HPEM-Pulse (36a-c) ansteuerbar sind,
- mit einem Eingang (72) und / oder einem Speicher (74) für wenigstens eine Missionsvorgabe (76) und / oder wenigstens eine Priorisierung (78) von Zielen in Bezug auf die Bekämpfung der Bedrohung (4),
- mit einer Steuereinrichtung (22), die dazu eingerichtet ist,
- der Bedrohung (4) wenigstens eines von mehreren vorgebbaren Bedrohungsszenarien (82) zuzuordnen,
- der Bedrohung (4) wenigstens eine von mehreren vorgebbaren Ziel-Klassen (84) zuzuordnen,
- der Bedrohung (4) abhängig von den zugeordneten Bedrohungs-Szenarien (82) und / oder den zugeordneten Ziel-Klassen (84) wenigstens eine von mehreren vorgebbaren HPEM-Charakteristiken (86) zuzuordnen,
- der Bedrohung (4) abhängig von den zugeordneten Bedrohungs-Szenarien (82) und / oder den zugeordneten Ziel-Klassen (84) und / oder den zugeordneten HPEM-Charakteristiken (86) wenigstens eine der HPEM-Quellen (6) zuzuordnen,
- die zugeordneten HPEM-Quellen (6) abhängig von
- den zugeordneten Bedrohungs-Szenarien (82) und / oder den zugeordneten Ziel-Klassen (84) und / oder den zugeordneten HPEM-Charakteristiken (86), und
- den Missionsvorgaben (76) und / oder den Priorisierungen (78)
- zur Bekämpfung der Bedrohung (4) anzusteuern,
**dadurch gekennzeichnet,**
**dass** die Wirkanordnung (2) wenigstens drei Quellen (6) enthält, die wahlweise und veränderbar zu Submodulen (42) von je wenigstens zwei Quellen (6) zusammenfassbar sind, und die Steueranordnung (22) dazu eingerichtet ist, die als aktuelles Submodul (42) organisierten Quellen (6) gemeinsam und unabhängig von anderen Quellen (6) anzusteuern.

2. Wirkanordnung (2) nach Anspruch 1,
**dadurch gekennzeichnet,**
**dass** wenigstens eine der Zielklassen eine auf eine Empfindlichkeit des Ziels (5) gegenüber HPEM-Pulsen (36a-c) abgestimmte Zielklasse ist.

3. Wirkanordnung (2) nach einem der vorhergehenden Ansprüche,
**dadurch gekennzeichnet,**
**dass** die Wirkanordnung (2) wenigstens ein Modul (8a-c) aufweist, das wenigstens eine der HPEM-Quellen (6) enthält.

4. Wirkanordnung (2) nach Anspruch 3,
**dadurch gekennzeichnet,**
**dass** wenigstens eines der Module (8a-c) als halbleiterbasiertes vollintegriertes Modul ausgeführt ist.

5. Wirkanordnung (2) nach einem der Ansprüche 3 bis 4,
**dadurch gekennzeichnet,**
**dass** wenigstens eines der Module (8a-c) wenigstens zwei der Quellen (6) enthält, die in Form eines Arrays (10) in fester Relativlage zueinander angeordnet sind.

6. Wirkanordnung (2) nach einem der vorhergehenden Ansprüche,
**dadurch gekennzeichnet,**
**dass** die Bedrohung (4) wenigstens zwei Ziele (5) enthält und die Steuereinrichtung (22) dazu eingerichtet ist, die Wirkanordnung (2) für wenigstens zwei der Ziele (5) parallel und unabhängig voneinander zu betreiben.

7. Wirkanordnung (2) nach einem der vorhergehenden Ansprüche,
**dadurch gekennzeichnet,**
**dass** die Steuereinrichtung (22) dazu eingerichtet ist, wenigstens zwei der Quellen (6) dadurch anzusteuern, dass diese miteinander zur Aussendung der HPEM-Pulse (36a-c) synchronisiert werden.

8. Wirkanordnung (2) nach einem der vorhergehenden Ansprüche,
**dadurch gekennzeichnet,**
**dass** die Steuereinrichtung (22) eine KI-Einrichtung (38) enthält oder ist.

9. Verfahren zur Bekämpfung einer Bedrohung (4) in Form wenigstens eines Ziels (5) mit Hilfe einer Wirkanordnung (2) nach einem der vorhergehenden Ansprüche, bei dem:
- wenigstens eine Missionsvorgabe (76) und / oder wenigstens eine Priorisierung (78) von Zielen in Bezug auf die die Bekämpfung der Bedrohung (4) bereitgestellt wird,
- die Steuereinrichtung (22):
- der Bedrohung (4) wenigstens eines von mehreren vorgebbaren Bedrohungsszenarien (82) zuordnet,
- der Bedrohung (4) wenigstens eine von mehreren vorgebbaren Ziel-Klassen (84) zuordnet,
- der Bedrohung (4) abhängig von den zugeordneten Bedrohungs-Szenarien (82) und / oder den zugeordneten Ziel-Klassen (84) wenigstens eine von mehreren vorgebbaren HPEM-Charakteristiken (86) zuordnet,
- der Bedrohung (4) abhängig von den zugeordneten Bedrohungs-Szenarien (82) und / oder den zugeordneten Ziel-Klassen (84) und / oder den zugeordneten HPEM-Charakteristiken (86) wenigstens eine der HPEM-Quellen (6) zuordnet,
- die zugeordneten HPEM-Quellen (6) abhängig von
- den zugeordneten Bedrohungs-Szenarien (82) und / oder den zugeordneten Ziel-Klassen (84) und / oder den zugeordneten HPEM-Charakteristiken (86), und
- den Missionsvorgaben (76) und / oder den Priorisierungen (78)
- zur Bekämpfung der Bedrohung (4) ansteuert.

## Claims

1. Effector arrangement (2) for combating a threat (4) in the form of at least one target (5),
- having at least two HPEM sources (6) configured to emit respective HPEM pulses (36a-c) in response to the threat (4),
- wherein at least two of the sources (6) can be controlled independently of each other to emit the HPEM pulses (36a-c),
- having an input (72) and/or a memory (74) for at least one mission specification (76) and/or at least one prioritization (78) of targets in relation to combating the threat (4),
- having a control device (22) configured
- to assign at least one of multiple predefinable threat scenarios (82) to the threat (4),
- to assign at least one of multiple predefinable target classes (84) to the threat (4),
- to assign at least one of multiple predefinable HPEM characteristics (86) to the threat (4) depending on the assigned threat scenarios (82) and/or the assigned target classes (84),
- to assign at least one of the HPEM sources (6) to the threat (4) depending on the assigned threat scenarios (82) and/or the assigned target classes (84) and/or the assigned HPEM characteristics (86),
- to control the assigned HPEM sources (6) depending on
- the assigned threat scenarios (82) and/or the assigned target classes (84) and/or the assigned HPEM characteristics (86), and
- the mission specifications (76) and/or the prioritizations (78)
- to combat the threat (4),
**characterized**
**in that** the effector arrangement (2) contains at least three sources (6) which can be optionally and modifiably combined to form submodules (42) of at least two sources (6) each, and the control arrangement (22) is configured to control the sources (6) organized as a current submodule (42) jointly and independently from other sources (6).

2. Effector arrangement (2) according to Claim 1, **characterized**
**in that** at least one of the target classes is a target class tuned to a sensitivity of the target (5) to HPEM pulses (36a-c).

3. Effector arrangement (2) according to one of the preceding claims,
**characterized**
**in that** the effector arrangement (2) has at least one module (8a-c) containing at least one of the HPEM sources (6).

4. Effector arrangement (2) according to Claim 3, **characterized**
**in that** at least one of the modules (8a-c) is designed as a semiconductor-based fully integrated module.

5. Effector arrangement (2) according to one of Claims 3 to 4,
**characterized**
**in that** at least one of the modules (8a-c) contains at least two of the sources (6) which are arranged in the form of an array (10) in a fixed relative position to each other.

6. Effector arrangement (2) according to one of the preceding claims,
**characterized**
**in that** the threat (4) contains at least two targets (5) and the control device (22) is configured to operate the effector arrangement (2) for at least two of the targets (5) in parallel and independently of each other.

7. Effector arrangement (2) according to one of the preceding claims,
**characterized**
**in that** the control device (22) is configured to control at least two of the sources (6) by virtue of the latter being synchronized with each other for the emission of the HPEM pulses (36a-c).

8. Effector arrangement (2) according to one of the preceding claims,
**characterized**
**in that** the control device (22) contains or is an AI device (38).

9. Method for combating a threat (4) in the form of at least one target (5) by means of an effector arrangement (2) according to one of the preceding claims, in which:
- at least one mission specification (76) and/or at least one prioritization (78) of targets in relation to combating the threat (4) is/are provided,
- the control device (22):
- assigns at least one of multiple predefinable threat scenarios (82) to the threat (4),
- assigns at least one of multiple predefinable target classes (84) to the threat (4),
- assigns at least one of multiple predefinable HPEM characteristics (86) to the threat (4) depending on the assigned threat scenarios (82) and/or the assigned target classes (84),
- assigns at least one of the HPEM sources (6) to the threat (4) depending on the assigned threat scenarios (82) and/or the assigned target classes (84) and/or the assigned HPEM characteristics (86),
- controls the assigned HPEM sources (6) depending on
- the assigned threat scenarios (82) and/or the assigned target classes (84) and/or the assigned HPEM characteristics (86), and
- the mission specifications (76) and/or the prioritizations (78)
- to combat the threat (4).

## Revendications

1. Agencement de ciblage (2) destiné à lutter contre une menace (4) sous la forme d'au moins une cible (5),
- comprenant au moins deux sources HPEM (6) qui sont conçues pour émettre des impulsions HPEM respectives (36a-c) vers la menace (4),
- au moins deux des sources (6) pouvant être commandées indépendamment l'une de l'autre pour l'émission des impulsions HPEM (36a-c),
- comprenant une entrée (72) et/ou une mémoire (74) pour au moins une spécification de mission (76) et/ou au moins une hiérarchisation (78) de cibles en relation avec la lutte contre la menace (4),
- comprenant un dispositif de commande (22) qui est conçu pour
- associer à la menace (4) au moins un scénario parmi une pluralité de scénarios de menace prédéfinissables (82),
- associer à la menace (4) au moins une classe de cibles parmi une pluralité de classes de cibles prédéfinissables (84),
- associer à la menace (4), en fonction des scénarios de menace associés (82) et/ou des classes de cibles associées (84), au moins l'une d'une pluralité de caractéristiques HPEM prédéfinissables (86),
- associer à la menace (4), en fonction des scénarios de menace associés (82) et/ou des classes de cibles associées (84) et/ou des caractéristiques HPEM associées (86), au moins l'une des sources HPEM (6),
- commander les sources HPEM associées (6) en fonction
- des scénarios de menace associés (82) et/ou des classes de cibles associées (84) et/ou des caractéristiques HPEM associées (86), et
- des spécifications de mission (76) et/ou des hiérarchisations (78)
- pour lutter contre la menace (4),
**caractérisé**
**en ce que** l'agencement de ciblage (2) contient au moins trois sources (6) qui peuvent être combinées sélectivement et de manière variable en sous-modules (42) d'au moins deux sources (6) chacun, et **en ce que** le dispositif de commande (22) est conçu pour commander les sources (6) effectivement organisées sous forme de sous-module (42) conjointement avec et indépendamment d'autres sources (6).

2. Agencement de ciblage (2) selon la revendication 1, **caractérisé**
**en ce qu'**au moins l'une des classes de cibles est une classe de cibles adaptée à une sensibilité de la cible (5) aux impulsions HPEM (36a-c).

3. Agencement de ciblage (2) selon l'une des revendications précédentes,
**caractérisé**
**en ce que** l'agencement de ciblage (2) comporte au moins un module (8a-c) qui contient au moins l'une des sources HPEM (6).

4. Agencement de ciblage (2) selon la revendication 3, **caractérisé**
**en ce qu'**au moins l'un des modules (8a-c) est réalisé sous la forme d'un module entièrement intégré à base de semi-conducteurs.

5. Agencement de ciblage (2) selon l'une des revendications 3 à 4,
**caractérisé**
**en ce qu'**au moins l'un des modules (8a-c) contient au moins deux des sources (6) qui sont disposées dans une position relative fixe l'une par rapport à l'autre sous la forme d'un réseau (10).

6. Agencement de ciblage (2) selon l'une des revendications précédentes,
**caractérisé**
**en ce que** la menace (4) contient au moins deux cibles (5) et le dispositif de commande (22) est conçu pour faire fonctionner l'agencement de ciblage (2) pour au moins deux des cibles (5) en parallèle et indépendamment l'une de l'autre.

7. Agencement de ciblage (2) selon l'une des revendications précédentes,
**caractérisé**
**en ce que** le dispositif de commande (22) est conçu pour commander au moins deux des sources (6) par synchronisation desdites sources l'une avec l'autre pour l'émission des impulsions HPEM (36a-c).

8. Agencement de ciblage (2) selon l'une des revendications précédentes,
**caractérisé**
**en ce que** le dispositif de commande (22) contient ou est un dispositif d'IA (38).

9. Procédé de lutte contre une menace (4) sous la forme d'au moins une cible (5) à l'aide d'un agencement de ciblage (2) selon l'une des revendications précédentes, dans lequel :
- il est fourni au moins une spécification de mission (76) et/ou au moins une hiérarchisation (78) de cibles en relation avec la lutte contre la menace (4),
- le dispositif de commande (22) :
- associe à la menace (4) au moins un scénario parmi une pluralité de scénarios de menace prédéfinissables (82),
- associe à la menace (4) au moins une classe de cibles parmi une pluralité de classes de cibles prédéfinissables (84),
- associe à la menace (4), en fonction des scénarios de menace associés (82) et/ou des classes de cibles associées (84), au moins l'une d'une pluralité de caractéristiques HPEM prédéfinissables (86),
- associe à la menace (4), en fonction des scénarios de menace associés (82) et/ou des classes de cibles associées (84) et/ou des caractéristiques HPEM associées (86), au moins l'une des sources HPEM (6),
- commander les sources HPEM associées (6) en fonction
- des scénarios de menace associés (82) et/ou des classes de cibles associées (84) et/ou des caractéristiques HPEM associées (86), et
- des spécifications de mission (76) et/ou des hiérarchisations (78)
- pour lutter contre la menace (4).
